# EUROPEAN PATENT APPLICATION

(11) **EP 0 846 785 A2**
(43) Date of publication of application: **10.06.1998**
(21) Application number: 97118243.1
(22) Date of filing: 21.10.1997
(51) Int. Cl.: C23C 14/22, H01L 23/00

(54) **A method of metalizing ceramic members**

(30) Priority: 03.12.1996 US 759865
(71) Applicant: HARRIS CORPORATION, Melbourne Florida 32912 (US)
(72) Inventor: Ozmat, Burhan, Voorhees, New York 12186 (US); Temple, Victor A. K., Clifton Park, New York 12065 (US); Murray, James R., Sr., Corinth, New York 12822 (US)
(74) Representative: Meddle, Alan Leonard

(57) **Abstract**

A method of metalizing a ceramic member (e.g., lid or thermal base) for a semiconductor power device with a film of aluminum in an ion vapor deposition chamber in which an argon ion cloud is formed around the member within the chamber (38) by biasing the member with a voltage and in which a continuous source of aluminum vapor (44) is provided within the chamber so that aluminum ions are available to be accelerated towards the member from plural directions by the bias voltage, the aluminum ions being formed from the aluminum vapor upon passage through the argon ion cloud.

## Description

The present invention relates to method of metalizing a ceramic, glass or glass ceramic member, and in particular to a method of depositing an aluminum film onto a ceramic member for a semiconductor power device using an inert gas-filled ion vapor deposition chamber having a continuous source of aluminum vapor within the chamber.

Microelectronic packages of discrete semiconductor power devices and power modules having multiple semiconductor power devices include ceramic members that are coated with a thin metal film. The metal film may be etched, as when the metalized ceramic member is a lid for semiconductor device package with patterned metal on its top and bottom and through holes, or the metal film may be continuous, as when the metalized ceramic member is a thermal base for a module of several power devices. The performance of the semiconductor power devices depend on the characteristics of these metalized ceramic members.

One of the known problems is the metal-to-ceramic adhesion of the metal film which is typically several thousandths of an inch thick. The adhesion may not be uniform, and may not be sufficient. For example, a copper coating process in which a ceramic is plated with electroless copper several microns thick and then electroplated with copper to the desired thickness provides an adhesion strength of ceramic to copper as low as a few hundred PSI (as measured by sebastian pin pull tests) which is inadequate for further processing and reliable operation. Further, if the metal is deposited with an ion beam, the thickness of the deposited metal is less likely to be uniform (see, for example, in the specification of U.S. Patent No. 4,828,870).

Another approach has been direct bond copper (DBC) eutectic bonding for metalzing a lid of power device package. DBC bonding is not compatible with high performance ceramics, such as AlN, which are likely to be preferred in advanced designs. Further, the bonding mechanism requires MₓO_{y} stoichiometry which increases manufacturing costs and complexity.

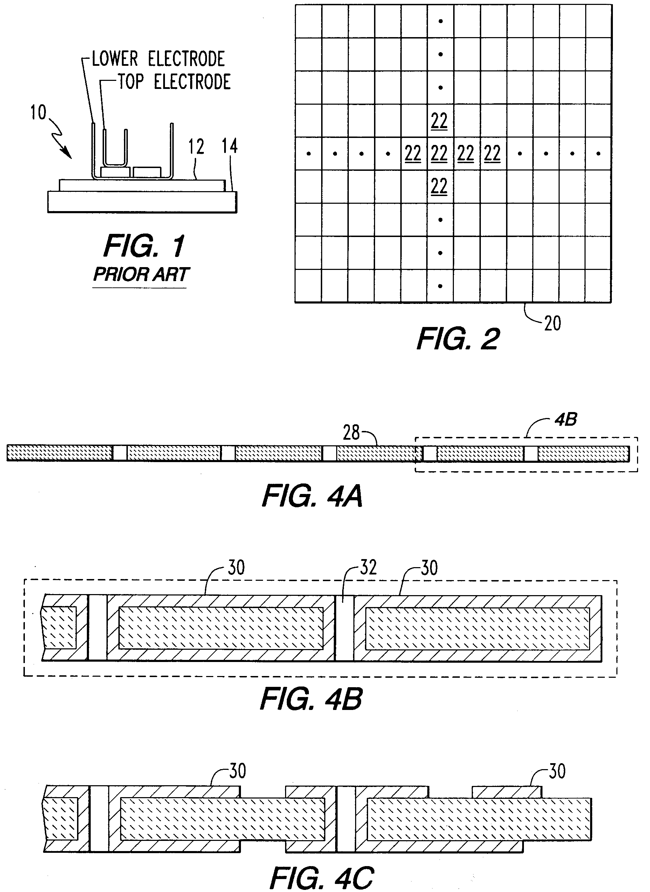

Another component of power packages and modules for which the present invention finds application is a electrically isolating thermal base. Thermal bases are parts of packages for advanced power devices and may be flat plates about 0.010 to 0.100 inches thick which range in size in plane from fractions of an inch to several inches. The core of a thermal base is a thermally conducting ceramic, such as AlN, and metalization may be provided over the entire ceramic core (or as much as needed). As depicted in Figure 1, one or more power device components 10 (e.g., a power switch) may be soldered to the thermal base 12 which is in turn mounted on a platform 14 which may be a heat exchanger or support frame.

The present invention may employ an ion vapor deposition (IVD) process for applying a coat of aluminum. The IVD process has been used to apply a protective coat of aluminum or other metals to parts of an aircraft fuselage and to various structural metals such as steel, but the process has not been used in the semiconductor industry to coat ceramic members for packaging semiconductor devices.

An object of the present invention is to provide a method of metalizing a ceramic member for a semiconductor power device package or module of semiconductor power devices to provide a novel method of metalizing a ceramic member in a vacuum chamber in which the member is surrounded with an inert gas ion cloud within the chamber, and a continuous source of metal vapor is provided within the chamber for forming metal ions which simultaneously metalize all exposed surfaces of the member.

Another object is to provide a method of metalizing a ceramic member for a semiconductor power device package or modules of power devices with a film of aluminum in an ion vapor deposition chamber in which the member is surrounded with an argon ion cloud within the chamber by charging the member with a bias voltage, and a continuous source of aluminum vapor is provided within the chamber so that aluminum ions are available to be accelerated towards the member simultaneously from plural directions by the bias voltage, the aluminum ions being formed upon passage of the aluminum vapor through the inert gas ion cloud.

The invention will now be described, by way of example, with reference to the accompanying drawings in which:
- Figure 1: is a side view of semiconductor power device of the prior art showing a thermal base between device components and a bottom platform.
- Figure 2: is a top plan view of an array of plural ceramic plates before separation.
- Figure 3A: is a top plan view of one plate form the array of Figure 1 with through holes.
- Figure 3B: is a plan view of an exemplary top surface of a metalized plate which has been patterned.
- Figure 3C: is a plan view of an exemplary bottom surface of a metalized plate which has been patterned.
- Figure 4A: is a vertical cross section of a lid with through holes, indicating a detail shown in Figures 4B and 4C.
- Figure 4B: is a vertical cross section of the detail indicated in Figure 4A illustrating metalization by the process before patterning.
- Figure 4C: is a vertical cross section of the detail indicated in Figure 4A illustrating metalization by the process after initial patterning.
- Figure 5: is a pictorial depiction of a frame fore holding an array of ceramic plates, such as the one illustrated in Figure 2.
- Figure 6: is a cut-away pictorial depiction of the interior of an ion vapor deposition chamber with a rack of framed arrays and heating crucible.

In a preferred embodiment an aluminum film is coated on a ceramic, glass or glass ceramic member by placing the ceramic, glass or glass ceramic member in an ion vapor deposition chamber so that the member's surfaces on which aluminum is to be deposited are exposed, filling the entire chamber with argon to the partial pressure of the argon, providing a continuous source of vaporized aluminum in the chamber, and applying a bias voltage to the member so that the argon is ionized and forms an argon ion cloud (i.e., a glow discharge) around the member and so that the vaporized aluminum is directed toward the member and is ionized by passage through the glow discharge to thereby deposit a film of aluminum on the exposed surfaces of the member. (Hereinafter, the terms "member" and "ceramic member" refer to a ceramic, glass or glass ceramic member.)

The collision of the aluminum and inert gas ions with the aluminum atoms in the vapor as the aluminum and inert gas ions are accelerated toward the negatively biased member creates more aluminum ions. The glow discharge surrounds the member so that the majority of the aluminum ions are created immediately adjacent the member. Thus, the method is not directional so that aluminum is deposited on all exposed surfaces simultaneously.

The aluminum vapor may be provided continuously by providing a source of aluminum wire in the chamber and feeding the aluminum wire from the source to a heating crucible (such as a resistance heated crucible) in the chamber so that the aluminum is vaporized. The bias voltage of one or more thousands of volts (e.g., up to about 4000 volts) may be applied continuously between the member (the cathode) and the anode in the chamber until the aluminum film is the desired thickness, typically between about 50 and 100 microns (e.g., a negative bias of 2000 volts may be applied for about four hours to achieve a preferred thickness of 50 to 75 microns at a deposition rate of better than 50 Å/sec.)

The ceramic member may be an array of semiconductor device plates, such as lids which may have a plurality of through holes, or thermal bases. The surfaces to be metalized may include the array top and bottom surfaces and interiors of the through holes.

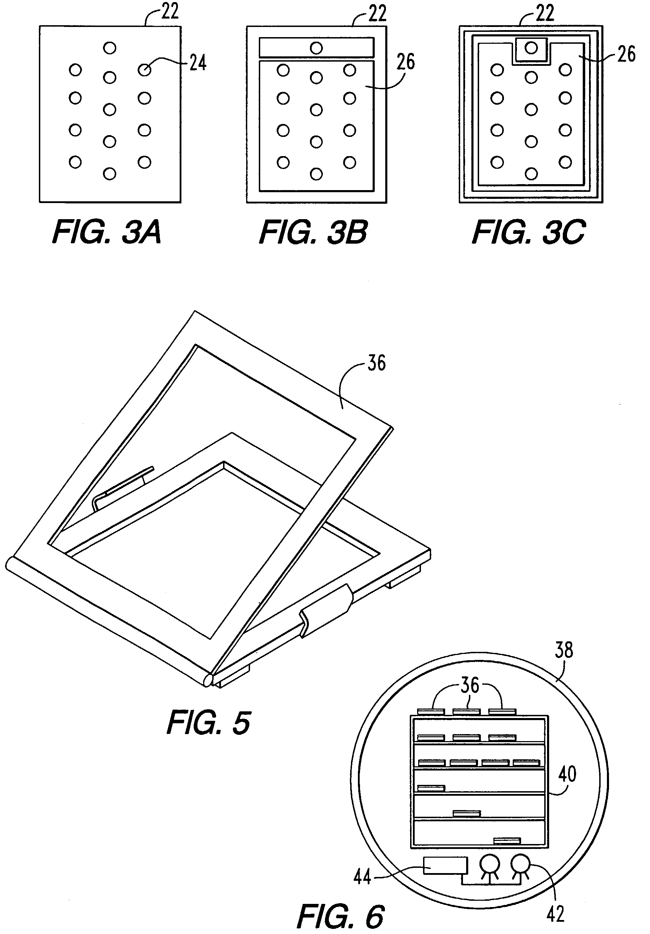

A power device may include a lid which has patterns of metalization on its top and bottom surfaces. Figure 2 shows the lids may be fabricated from a sheet of ceramic 20 which has been laser machined and scribed to form an array of lids 22. As shown in Figure 3A which illustrates one of the lids 22, lid 22 may be provided with through holes 24. The top surface of the lid (Figure 3B) and bottom surface (Figure 3C) may be patterned with metal 26 as needed. The pattern may match the pattern of solderable metalization on the semiconductor device. The preferred method of further assembly in which devises, diodes, electrodes and the like are attached is a single or multiple step soldering process using a single alloy or alloys with an appropriate melting point hierarchy. This approach eliminates the need for traditional wire bonding to make contacts to external electrodes and, thus, eliminates wire fatigue and fracturing of brittle semiconductor dies under the stress of wire bonding. The invention improves the method of metalzing the lid before it is patterned and, thus, increases the compatibility of the lid with the subsequent processing steps. The metalized lid with through holes that form an electrically conductive path from top to bottom surface offers a very low inductance connection to external electrodes as needed by high current/power advance discrete power packages and modules.

Figures 4A-C illustrate a lid 28 in vertical cross-section (Figure 4A), and show a detail of the metalization 30 of the present invention covering the surfaces of the lid, including the interiors of through holes 32 before subsequent patterning (Figure 4B) and after a first patterning step (Figure 4C) toward achieving the pattern of Figure 3C.

The method also can be used to provide a soft and thick aluminum layer of high purity and low modules which acts as a stress-relieving cushion for the brittle ceramic plate at the core of a thermal base. This is a particular advantage for a thermal base used in a power device module such as a power electronic building block (PEBB). As illustrated in Figure 1, power components are attached to thermal base 12 which is in turn attached to platform 14 which may be a heat exchanger or support frame. Thermal base 12 may be metalized by the process herein and further plated with a nickel coat to form a solderable metalization for attachment of the components. The stress-relieving cushion provided by the aluminum metalization increases reliability of the modules in the face of subsequent handling and assembly related stresses. The two sided aluminum metalization provided herein also facilitates attachment of thermal bases 12 directly to the underlying platform 14 with screws.

The ion vapor deposition of the aluminum on the ceramic member improves the metallic adhesion to several thousand PSI which is high enough to cause the member to fail first in sebastian pull tests. The member may be cleaned to improve adhesion by sputter cleaning the member in the chamber with an argon plasma before vaporizing the aluminum in the chamber.

The ceramic member may be an appropriate ceramic, glass or glass ceramic, such as alumina, aluminum nitride, beryllium oxide, silicon carbide, and silicon nitride. While the use of argon to form the glow discharge and aluminum to metalize the member is preferred, other appropriate inert gases and metals may be used.

With references now to Figures 5 and 6, the process may include placement of an array of the lids or bases (such as in Figure 2) in a frame 36, and placement of a plurality of the frames 36 in a vacuum chamber such as IVD chamber 38 on a rack 40 with one or more heating crucibles 42 fed from a source of aluminum 44 in the chamber for providing the continuous source of aluminum vapor. Commercially available IVD chambers can accommodate several hundred 4.5" x 4.5" x 0.025" ceramic arrays.

The ceramic members made by the method described herein provide advantages in structural reliability and electrical performance for discrete power packages and multiple power device modules which contain high power/high current semiconductor devices. Heretofore, such packages and modules have included multiple bond wires with high inductance and low structural reliability. High reliability, high currents and high switching speeds are required in a myriad of applications (e.g., automotive applications, high power industrial and military motor drives, voltage and frequency converters.) The devices made by the method herein include electrical feed-throughs which may be directly soldered to the matched solderable material pattern in the device to provide reliable, low inductance connections for a variety of semiconductor devices such as IGBTs, MCTs, CMOS devices.

A method of metalizing a ceramic member (e.g., lid or thermal base) for a semiconductor power device with a film of aluminum in an ion vapor deposition chamber in which an argon ion cloud is formed around the member within the chamber by biasing the member with a voltage and in which a continuous source of aluminum vapor is provided within the chamber so that aluminum ions are available to be accelerated towards the member from plural directions by the bias voltage, the aluminum ions being formed from the aluminum vapor upon passage through the argon ion cloud.

## Claims

1. A method of metalizing a ceramic member for a semiconductor power device with a film of aluminum in an ion vapor deposition chamber comprising the steps of surrounding the member with an inert gas ion cloud within the chamber by applying a bias voltage to the member, characterized by a continuing source of aluminum vapor within the chamber so that aluminum ions are available to be accelerated towards the member from plural directions by the bias voltage, the aluminum ions being formed from the aluminum vapor upon passage of aluminum atoms in the aluminum vapor through the inert gas ion cloud in which the inert gas is argon and the step of providing an aluminum vapor comprises the steps of providing a source of aluminum in the chamber and heating the aluminum in the chamber so that the aluminum is vaporized.

2. A method as claimed in Claim 1 characterized in that the bias voltage is up to 4000 volts.

3. A method as claimed in Claim 1 or 2 characterized in that the member is an array of plates, and the surfaces of the plates on which the aluminum film is to be deposited include their tops and bottoms and preferably the plates have a plurality of through holes, and the surfaces on which the aluminum film is to be deposited include the interiors of the through holes.

4. A method of depositing an aluminum film on a ceramic member, characterized by the steps of:
(a) placing a ceramic member in a vacuum chamber so that the member's surfaces on which aluminum is to be deposited are exposed;
(b) filling the chamber with a cloud of argon;
(c) vaporizing aluminum in the chamber; and
(d) applying a bias voltage to the member so that the argon is ionized and forms a glow discharge around the member and so that the vaporized aluminum is directed toward the member and is ionized by passage through the glow discharge to thereby deposit a film of aluminum on the surfaces of the member in which the step of filling the vacuum chamber comprises the step of filling the vacuum chamber at the argon's partial pressure.

5. A method as claimed in Claim 4 characterized in that the step of vaporizing aluminum comprises the steps of providing a continuous source of aluminum wire in the chamber and feeding the aluminum wire from the source to a heating crucible in the chamber so that the aluminum is vaporized, the member comprises an array of semiconductor device ceramic plates, and the surfaces of the plates on which the aluminum film is to be deposited includes their tops and bottoms.

6. A method as claimed in Claims 4 or 5 characterized in that the plates are one of lids for semiconductor power device packages and thermal bases for semiconductor power device modules, in which the step of applying a bias voltage comprises the step of applying the bias voltage until the aluminum film is, approximately, less than or equal to 100 microns thick.

7. A method as claimed in Claim 6 characterized by the step of sputter cleaning the member in situ with an argon plasma before vaporizing the aluminum in the chamber.

8. A method of depositing an aluminum film on a top and a bottom of an array of semiconductor device ceramic plates, characterized by the steps of:
(a) placing an array of semiconductor device ceramic plates in a vacuum chamber so that the array's top and bottom surfaces on which aluminum is to be deposited are exposed;
(b) filling the chamber with a cloud of argon at the partial pressure of the argon;
(c) providing a source of aluminum wire in the chamber and feeding the aluminum wire from the source to a heating crucible in the chamber so that the aluminum is evaporated in the chamber; and
(d) applying a bias voltage to the array so that the argon is ionized and so that the aluminum is directed toward at least the top and bottom of the array until a film of aluminum, approximately, 50 to 100 µm thick is deposited on the top and bottom surfaces of the array in which the step of applying the bias voltage comprises the steps of ionizing the argon to form a glow discharge around the array and the aluminum directed toward the array is ionized by passage through the glow discharge.

9. A method as claimed in Claim 8 characterized in that the rate of aluminum deposition exceeds 50 Å/sec.

10. A method as claimed in any one of claims 1 to 9 characterized by the array comprising a material selected from the group consisting of alumina, aluminum nitride, beryllium oxide, silicon carbide and silicon nitride, and the step of applying the bias voltage comprises the step of applying the bias voltage until the aluminum film is between 50 and 75 microns thick.

11. A method of adhering a stress-relieving metal film to a top and a bottom of a ceramic member for a semiconductor device, characterized by the steps of placing the member in an inert gas-filled vacuum chamber with vaporized metal therein, and applying a bias voltage to the member so that the inert gas is ionized and forms a glow discharge around member and so that the metal vapor is directed toward the top and bottom of the member and is ionized by passage though the glow discharge to thereby deposit a stress-relieving metal film on the top and bottom of the member in which the metal is aluminum and the deposition of the film on the top and bottom of the member is at the rate of at least 100 µm in four hours using the inert gas argon and the chamber filled to the partial pressure of the argon.

12. A method as claimed in Claim 10 characterized in that the step of applying a bias voltage comprises the step of applying the bias voltage until the metal film is 50 to 100 microns thick.
